# EUROPÄISCHE PATENTSCHRIFT

(11) **EP 4 030 872 B1**
(45) Veröffentlichungstag und Bekanntmachung des Hinweises auf die Patenterteilung: **05.03.2025**
(21) Anmeldenummer: 22150010.1
(22) Anmeldetag: 03.01.2022
(51) Int. Cl.: H05B 45/50, H01L 23/525

(54) **LED-TREIBER MIT LEITERBAHN-SCHMELZSICHERUNG**
LED DRIVER WITH CONDUCTOR FUSE
EXCITATEUR À DEL POURVU DE FUSIBLE DE PISTE CONDUCTRICE

(30) Priorität: 13.01.2021 DE 202020110011 U
(43) Veröffentlichungstag der Anmeldung: 20.07.2022
(73) Patentinhaber: Tridonic GmbH & Co KG, 6851 Dornbirn (AT)
(72) Erfinder: Wynnyczenko, Oliver, 6850 Dornbirn (AT); Maldoner, Jakob, 6850 Dornbirn (AT); Hrach, Jürgen, 6850 Dornbirn (AT)
(74) Vertreter: Rupp, Christian

(56) Entgegenhaltungen:
- WO-A1-2019/062781
- DE-A1- 102016 114 985

## Beschreibung

Die vorliegende Anmeldung betrifft ganz allgemein Beleuchtungstechnik, und insbesondere einen per Leiterbahn-Schmelzsicherung abgesicherten Treiber für LED-Leuchtmittel (LED-Treiber).

DE 10 2016 114 985 A1 beschreibt eine Lichtabgabesteuervorrichtung, welche ein aus Metall gefertigtes Gehäuse und eine Leiterplatte mit Anschlusssockeln umfasst. Eine Schutzabdeckung ist an einer oberen Seite der Leiterplatte befestigt. Die Schutzabdeckung ist aus einem synthetischen Harz mit einer elektrischen Isoliereigenschaft gefertigt. Die Schutzabdeckung schützt Schaltungskomponenten, die auf der Leiterplatte montiert sind, mit Ausnahme der Anschlusssockel.

Schmelzsicherungen dienen als netzanschlussseitiger Überstromschutz für LED-Treiber. Ein Auslösen solcher Sicherungen kann heiße Gase und/oder Splittermaterial freisetzen. Diesbezüglich besteht die regulatorische Anforderung, solche heißen Gase und/oder Splittermaterial nicht aus einem Gehäuse des LED-Treibers entweichen zu lassen, in welchem die Sicherung angeordnet ist (vgl. IEC 61347).

Besonders risikoreich sind LED-Treiber in einem Gleichstrom-Betrieb, da bei diesen die Sicherung oftmals nahe des Gleichstrom-Anschlusses und somit nahe einer Gleichstrom-Anschlussöffnung des Gehäuses angeordnet ist. Dies erhöht ganz offensichtlich das Risiko, dass heiße Gase und/oder Splittermaterial aus dieser Öffnung entweichen. Ein eventuell beim Auslösen entstehender Funken oder Lichtbogen kann mangels Nulldurchgang der Gleichspannung länger fortbestehen. Spezielle, für Gleichstrom-Betrieb ausgelegte Sicherungen sind kostenintensiv und weisen einen großen Formfaktor auf.

Jedoch können bereits sich innerhalb des Gehäuses ausbreitende heiße Gase für sich problematisch sein, sofern diese bis zu Anschlussflächen des Netzanschlusses hin freigesetzt werden. Diese Anschlussflächen sind standardkonform ausgelegt, d.h. mit Sicherheits- und Kriechwegabständen, welche keine heißen Gase berücksichtigen, und können im Beisein heißer Gase kurzgeschlossen werden.

Demzufolge ist es erforderlich, eine Betriebssicherheit von LED-Treibern bei Gleichstrom-Betrieb zu verbessern.

Erfindungsgemäß wird diese Aufgabe durch den unabhängigen Schutzanspruch 1 gelöst. Bevorzugte Ausführungsformen werden in den abhängigen Schutzansprüchen sowie in der Beschreibung und den Zeichnungen definiert.

Ein Aspekt der vorliegenden Anmeldung betrifft einen LED-Treiber. Der LED-Treiber weist ein elektrisch leitfähiges Gehäuse, eine Hauptplatine und zumindest eine Folie zwischen dem Gehäuse und der Hauptplatine auf. Die Hauptplatine weist Schaltungskomponenten zum Regeln einer zwischen einem Netzanschluss und einem Gleichstrom-Anschluss des LED-Treibers übertragenen elektrischen Leistung, und eine Leiterbahn-Sicherung zum Schutz des LED-Treibers vor elektrischer Überlastung auf. Die zumindest eine Folie ist derartig ausgebildet, dass sie einen Luftspalt zwischen sich und der Hauptplatine im Wesentlichen ausfüllt und den Netzanschluss von Emissionen infolge eines Auslösens der Sicherung abschirmt.

Die zumindest eine Folie kann eine Folie mit einem das Gehäuse auskleidenden Hauptabschnitt, einem daran anschließenden Umschlagfalzabschnitt und einem daran anschließenden Stehfalzabschnitt umfassen.

Der Umschlagfalzabschnitt kann über eine Umschlagfalzlinie in das Gehäuse hinein falzbar sein.

Der Stehfalzabschnitt kann über eine Stehfalzlinie von dem Umschlagfalzabschnitt abstehend falzbar sein.

Der Umschlagfalzabschnitt, der Stehfalzabschnitt und die Hauptplatine können in einer Richtung der Falzlinien im Wesentlichen identisch bemessen sein.

Der Umschlagfalzabschnitt kann in einer zu der Umschlagfalzlinie senkrechten Richtung derartig bemessen sein, dass der in das Gehäuse hinein gefalzte Umschlagfalzabschnitt zwischen dem Netzanschluss und der Sicherung abschließt.

Der Stehfalzabschnitt kann in einer zu der Stehfalzlinie senkrechten Richtung derartig bemessen sein, dass der von dem Umschlagfalzabschnitt abstehend gefalzte Stehfalzabschnitt den Luftspalt zwischen der Folie und der Hauptplatine im Wesentlichen ausfüllt.

Die zumindest eine Folie kann eine das Gehäuse auskleidende Folie und eine weitere Folie mit einem Hauptabschnitt und einen Stehfalzabschnitt umfassen.

Der Stehfalzabschnitt der weiteren Folie kann über eine Stehfalzlinie von der weiteren Folie abstehend falzbar sein.

Die weitere Folie kann derartig zwischen der einen Folie und der Hauptplatine angeordnet sein, dass die Stehfalzlinie der weiteren Folie zwischen dem Netzanschluss und der Sicherung angeordnet und im Wesentlichen parallel zu der Stehfalzlinie der Folie ausgerichtet ist.

Der Hauptabschnitt der weiteren Folie, der Stehfalzabschnitt der weiteren Folie und die Hauptplatine können in einer Richtung der Stehfalzlinie der weiteren Folie im Wesentlichen identisch bemessen sein.

Der Stehfalzabschnitt der weiteren Folie kann in einer zu dessen Stehfalzlinie senkrechten Richtung derartig bemessen sein, dass der von der weiteren Folie abstehend gefalzte Stehfalzabschnitt den Luftspalt zwischen der einen Folie und der Hauptplatine im Wesentlichen ausfüllt.

Weitere Merkmale, Vorteile und Eigenschaften der vorliegenden Erfindung werden nun anhand von Ausführungsbeispielen unter Bezugnahme auf die Figuren der begleitenden Zeichnungen erklärt.
Fig. 1 zeigt schematisch einen erfindungsgemäßen LED-Treiber;
Fig. 2 bis 5 zeigen die Folie gemäß einer Ausführungsform des erfindungsgemäßen LED-Treibers;
Fig. 6 und 7 zeigen eine bekannte Folie;
Fig. 8 und 9 zeigen eine weitere Folie gemäß einer Ausführungsform des erfindungsgemäßen LED-Treibers.
Fig. 10 und 11 zeigen eine weitere Folie gemäß einer weiteren Ausführungsform des erfindungsgemäßen LED-Treibers.

Die Offenbarung wird nun unter Bezugnahme auf die verschiedenen Ausführungsbeispiele näher erläutert. Sofern nicht anderweitig angegeben sind Merkmale verschiedener Ausführungsbeispiele miteinander kombinierbar.

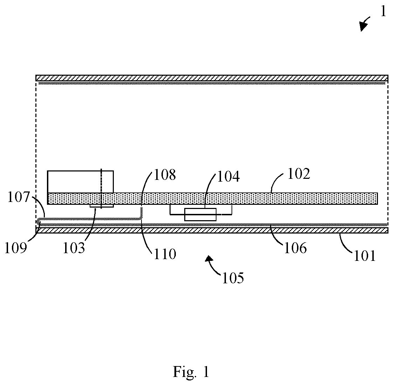

Fig. 1 zeigt schematisch einen erfindungsgemäßen LED-Treiber 1.

Der LED-Treiber 1 weist ein insbesondere aus Metall hergestelltes, elektrisch leitfähiges Gehäuse 101, eine Hauptplatine 102 und zumindest eine Folie 105, 105', 105" zwischen dem Gehäuse 101 und der Hauptplatine 102 auf.

Die Hauptplatine 102 weist Schaltungskomponenten zum Regeln einer zwischen einem Netzanschluss 103 und einem Gleichstrom-Anschluss des LED-Treibers 1 übertragenen elektrischen Leistung, und eine Leiterbahn-Sicherung 104 zum Schutz des LED-Treibers 1 vor elektrischer Überlastung auf.

Die Sicherung 104 ist in Fig. 1 nur der besseren Darstellbarkeit wegen als Komponenten-Sicherung abgebildet, ist jedoch als Leiterbahn-Sicherung ausgeführt.

In einer ersten Ausführungsform (vgl. Fig. 1 - 5) umfasst die zumindest eine Folie 105, 105', 105" eine Folie 105 mit einem das Gehäuse 101 auskleidenden Hauptabschnitt 106, einem daran anschließenden Umschlagfalzabschnitt 107 und einem daran anschließenden Stehfalzabschnitt 108 umfasst.

Der Hauptabschnitt 105 dient zur Potentialtrennung zwischen dem elektrisch leitfähigen Gehäuse 101 des LED-Treibers 1 und der Hauptplatine 102 des LED-Treibers 1. Ein Langloch im Hauptabschnitt 105 stellt eine definierte Masseverbindung zwischen der Hauptplatine 102 und dem Gehäuse 101 bereit, d.h. es handelt sich um eine Aussparung, die eine gehäuseseitige Auflage für die Hauptplatine 102 umgreift.

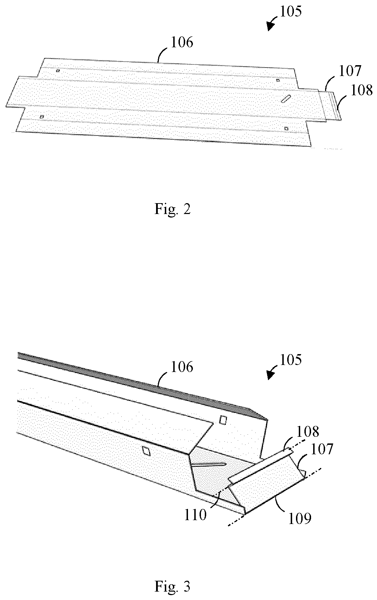

Die eine Folie 105 weist gemäß Fig. 2 vier Falzlinien auf, welche parallel zueinander in Richtung einer längeren Abmessung der Folie 105 verlaufen und dazu dienen, aus der ebenen einen Folie 105 der Fig. 2 die schachtartig gefaltete eine Folie 105 der Fig. 3 zu bilden, welche das geringfügig größer ausgebildete Gehäuse 101 des LED-Treibers 1 auskleiden und selbst die Hauptplatine 102 des LED-Treibers 1 aufnehmen kann.

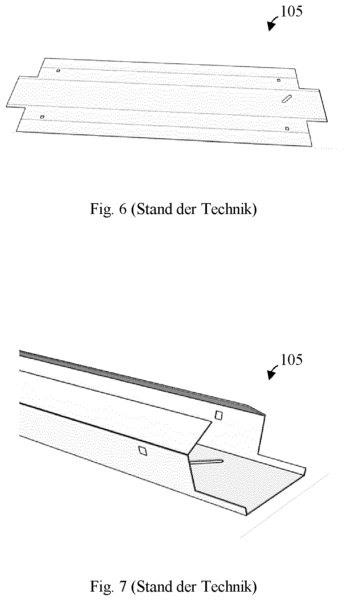

Die eine Folie 105 des erfindungsgemäßen LED-Treibers 1 aus Fig. 1 umfasst im Vergleich zu einer bekannten, in Fig. 6 - 7 abgebildeten einen Folie 105 einen Fortsatz. Den Fig. 1 - 5 kann entnommen werden, dass an den das Gehäuse 101 auskleidenden Hauptabschnitt 106 ein Umschlagfalzabschnitt 107 anschließt.

Ein "Falz" kann sich insbesondere auf eine scharfe Knickkante (Falzlinie) in einem flächigen Material beziehen, dessen Dicke um mindestens eine Größenordnung geringer ist als seine seitlichen Abmessungen.

Ein "Umschlagfalz" kann sich insbesondere auf einen Falz beziehen, dessen flächiges Material an der scharfen Knickkante (Umschlagfalzlinie) einen Winkel von im Wesentlichen 0° einschließt, sodass Abschnitte des flächigen Materials aufeinander zu liegen kommen.

Ein "Umschlagfalzabschnitt" kann sich insbesondere auf einen an eine Umschlagfalzlinie anschließenden Abschnitt des flächigen Materials beziehen.

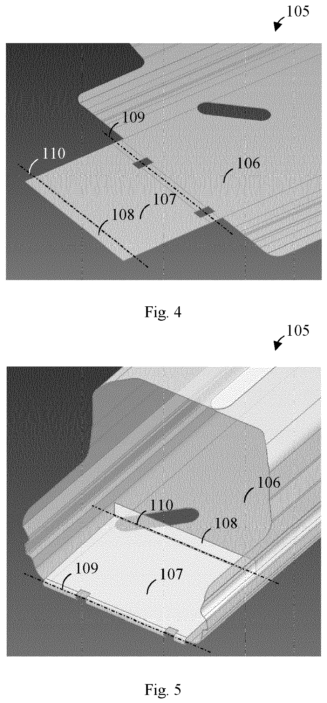

Der Umschlagfalzabschnitt 107 kann über eine Umschlagfalzlinie 109 (vgl. Fig. 3 - 5) in das Gehäuse 101 hinein falzbar sein. Fig. 1 und 5 zeigen den bereits in das Gehäuse 101 hinein gefalzten Umschlagfalzabschnitt 107.

Gemäß Fig. 1 - 5 schließt sich an den Umschlagfalzabschnitt 107 zudem ein Stehfalzabschnitt 108 an.

Ein "Stehfalz" kann sich insbesondere auf einen Falz beziehen, dessen flächiges Material an der scharfen Knickkante (Stehfalzlinie) einen Winkel zwischen 45° und 135°, bevorzugt zwischen 60° und 120°, mehr bevorzugt zwischen 75° und 105°, und ganz besonders bevorzugt einen Winkel von im Wesentlichen 90° einschließt.

Ein "Stehfalzabschnitt" kann sich insbesondere auf einen an eine Stehfalzlinie anschließenden Abschnitt des flächigen Materials beziehen.

Der Stehfalzabschnitt 108 kann über eine Stehfalzlinie 110 (vgl. Fig. 3 - 5) von dem Umschlagfalzabschnitt 107 abstehend falzbar sein. Fig. 1 und 5 zeigen den bereits von dem Umschlagfalzabschnitt 107 abstehend gefalzten Stehfalzabschnitt 108.

Der Umschlagfalzabschnitt 107, der Stehfalzabschnitt 108 und die Hauptplatine 102 können in einer Richtung der Falzlinien 109, 110 im Wesentlichen identisch bemessen sein.

Eine "Bemessung" kann sich insbesondere auf eine Längenabmessung eines körperlichen Gegenstands in einer angegebenen Raumrichtung beziehen.

Der Umschlagfalzabschnitt 107 kann in einer zu der Umschlagfalzlinie 109 senkrechten Richtung derartig bemessen sein, dass der in das Gehäuse 101 hinein gefalzte Umschlagfalzabschnitt 107 zwischen dem Netzanschluss 103 und der Sicherung 104 abschließt.

Der Stehfalzabschnitt 108 kann in einer zu der Stehfalzlinie 110 senkrechten Richtung derartig bemessen sein, dass der von dem Umschlagfalzabschnitt 107 abstehend gefalzte Stehfalzabschnitt 108 den Luftspalt zwischen der einen Folie 105 und der Hauptplatine 102 im Wesentlichen ausfüllt. Eine vollständige Abdichtung ist dabei nicht erforderlich. Der Zweck wird bereits dann erfüllt, wenn das Freisetzen von Material beim Auslösen der Sicherung 104 zuverlässig verhindert wird.

Demzufolge ist die eine Folie 105 des erfindungsgemäßen LED-Treibers 1 derartig ausgebildet, dass sie den Netzanschluss 103, und insbesondere dessen Anschlussflächen auf einer Hauptplatinenseite der Sicherung 104, von Emissionen infolge eines Auslösens der Sicherung 104 abschirmt.

Dadurch wird der ungünstige Fall unterbunden, dass heiße Gase infolge eines Auslösens der Sicherung 104 bis zu den Anschlussflächen des Netzanschlusses 103 hin freigesetzt werden. Das Material der Anschlussflächen wird geschützt, sodass eine verbesserte Betriebssicherheit des LED-Treibers 1 bei Gleichstrom-Betrieb erzielbar ist.

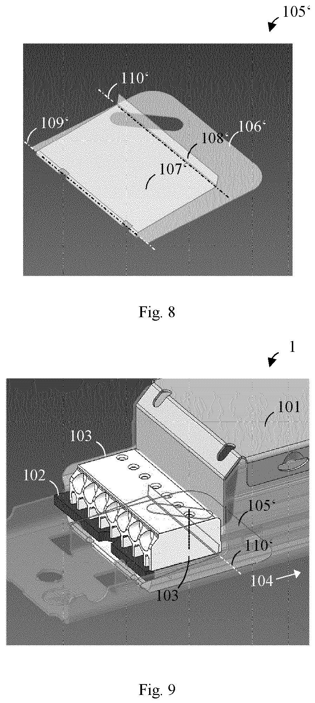

In einer zweiten Ausführungsform umfasst die zumindest eine Folie 105, 105', 105" eine das Gehäuse 101 auskleidende Folie 105 (vgl. Fig. 6 - 7) und eine weitere Folie 105' (vgl. Fig. 8 - 9).

Die eine, das Gehäuse 101 auskleidende Folie 105 kann beispielsweise eine bekannte Folie 105 sein, wie sie in den Fig. 6 und 7 veranschaulicht ist. Dies könnte etwa produktionstechnisch bedingt sein, um sich eine Investition in neue Werkzeuge zu ersparen.

Die weitere Folie 105' kann einen Hauptabschnitt 106' und einen Stehfalzabschnitt 108' umfassen. Sie kann bei der Fertigung des LED-Treibers 1 einfach zusätzlich auf die eine Folie 105 aufgelegt werden.

Ein Langloch im Hauptabschnitt 106' dient wie bereits zuvor erwähnt zur Bereitstellung einer definierten Masseverbindung zwischen der Hauptplatine 102 und dem Gehäuse 101.

Wie der Fig. 8 und 9 zu entnehmen ist kann diese Ausführungsform darüber hinaus einen den Hauptabschnitt 106' und den Stehfalzabschnitt 108' verbindenden Umschlagfalzabschnitt 107` aufweisen. Der Umschlagfalzabschnitt 107` kann über eine Umschlagfalzlinie 109' auf den Hauptabschnitt 106' zurück falzbar sein. Fig. 8 und 9 zeigen den bereits auf den Hauptabschnitt 106' zurück gefalzten Umschlagfalzabschnitt 107'.

Der Stehfalzabschnitt 108' der weiteren Folie 105' kann über eine Stehfalzlinie 110' von der weiteren Folie 105' abstehend falzbar sein. Fig. 8 und 9 zeigen den bereits von der weiteren Folie 105', genauer gesagt von dem Umschlagfalzabschnitt 107' abstehend gefalzten Stehfalzabschnitt 108.

Wie insbesondere Fig. 9 zu entnehmen ist, können der Hauptabschnitt 106' der weiteren Folie 105', der Stehfalzabschnitt 108' der weiteren Folie 105' und die Hauptplatine 102 in einer Richtung der Stehfalzlinie 110' der weiteren Folie 105' im Wesentlichen identisch bemessen sein. Auch auf den Umschlagfalzabschnitt 107` der weiteren Folie 105' kann diese Bemessung zutreffen.

Der Stehfalzabschnitt 108' der weiteren Folie 105' kann in einer zu dessen Stehfalzlinie 110' senkrechten Richtung derartig bemessen sein, dass der von der weiteren Folie 105' abstehend gefalzte Stehfalzabschnitt 108' den Luftspalt zwischen der einen Folie 105 und der Hauptplatine 102 im Wesentlichen ausfüllt.

Wie insbesondere Fig. 9 zu entnehmen ist, kann die weitere Folie 105' derartig zwischen der einen Folie 105 und der Hauptplatine 102 angeordnet sein, dass die Stehfalzlinie 110' der weiteren Folie 105' zwischen dem Netzanschluss 103 und der Sicherung 104 angeordnet und im Wesentlichen parallel zu der Stehfalzlinie 110 der einen Folie 105 ausgerichtet ist.

Demzufolge ist die weitere Folie 105' des erfindungsgemäßen LED-Treibers 1 derartig ausgebildet, dass sie den Netzanschluss 103, und insbesondere dessen Anschlussflächen auf der Hauptplatinenseite der Sicherung 104, von Emissionen infolge eines Auslösens der Sicherung 104 abschirmt.

Auch dadurch wird der ungünstige Fall unterbunden, dass heiße Gase infolge eines Auslösens der Sicherung 104 bis zu den Anschlussflächen des Netzanschlusses 103 hin freigesetzt werden. Das Material der Anschlussflächen wird geschützt, sodass eine verbesserte Betriebssicherheit des LED-Treibers 1 bei Gleichstrom-Betrieb erzielbar ist.

In Verbindung mit der einen Folie 105 der Fig. 6 - 7 ist neben der Potentialtrennung eine Abschirmung heißer Gase erzielbar.

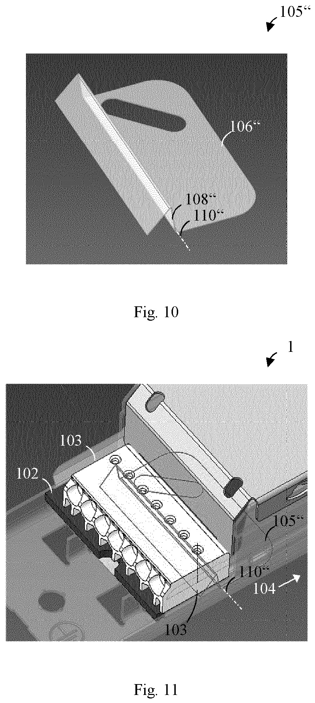

In einer dritten Ausführungsform umfasst die zumindest eine Folie 105, 105', 105" die eine das Gehäuse 101 auskleidende Folie 105 (vgl. Fig. 6 - 7) und eine weitere Folie 105" (vgl. Fig. 10 - 11).

Die weitere Folie 105" kann einen Hauptabschnitt 106" und einen Stehfalzabschnitt 108" umfassen.

Ein Langloch im Hauptabschnitt 106" dient dem bereits zuvor offenbarten Zweck der Bereitstellung einer definierten Masseverbindung zwischen der Hauptplatine 102 und dem Gehäuse 101.

Wie den Fig. 10 - 11 zu entnehmen ist kann in dieser Ausführungsform der Stehfalzabschnitt 108" direkt an den Hauptabschnitt 106" anschließen, wobei der Stehfalzabschnitt 108" einen gefalzten Fortsatz umfassen kann. Der Stehfalzabschnitt 108" der weiteren Folie 105" kann über eine Stehfalzlinie 110" von der weiteren Folie 105" abstehend falzbar sein. Fig. 10 und 11 zeigen den bereits von der weiteren Folie 105", genauer gesagt von deren Hauptabschnitt 106" abstehend gefalzten Stehfalzabschnitt 108".

Wie insbesondere Fig. 11 zu entnehmen ist, können der Hauptabschnitt 106" der weiteren Folie 105", der Stehfalzabschnitt 108" der weiteren Folie 105" und die Hauptplatine 102 in einer Richtung der Stehfalzlinie 110" der weiteren Folie 105" im Wesentlichen identisch bemessen sein. Auch auf den gefalzten Fortsatz des Stehfalzabschnitts 108" kann diese Bemessung zutreffen.

Der Stehfalzabschnitt 108" der weiteren Folie 105" kann in einer zu dessen Stehfalzlinie 110" senkrechten Richtung derartig bemessen sein, dass der von der weiteren Folie 105" abstehend gefalzte Stehfalzabschnitt 108" den Luftspalt zwischen der einen Folie 105 und der Hauptplatine 102 im Wesentlichen ausfüllt.

Wie insbesondere Fig. 11 zu entnehmen ist, kann die weitere Folie 105" derartig zwischen der einen Folie 105 und der Hauptplatine 102 angeordnet sein, dass die Stehfalzlinie 110" der weiteren Folie 105" zwischen dem Netzanschluss 103 und der Sicherung 104 angeordnet und im Wesentlichen parallel zu der Stehfalzlinie 110 der Folie 105 ausgerichtet ist.

Demzufolge ist auch die weitere Folie 105" des erfindungsgemäßen LED-Treibers 1 derartig ausgebildet, dass sie den Netzanschluss 103, und insbesondere dessen Anschlussflächen auf der Hauptplatinenseite der Sicherung 104, von Emissionen infolge eines Auslösens der Sicherung 104 abschirmt.

Wiederum wird so der ungünstige Fall unterbunden, dass heiße Gase infolge eines Auslösens der Sicherung 104 bis zu den Anschlussflächen des Netzanschlusses 103 hin freigesetzt werden. Das Material der Anschlussflächen wird geschützt, sodass eine verbesserte Betriebssicherheit des LED-Treibers 1 bei Gleichstrom-Betrieb erzielbar ist.

In Verbindung mit der einen Folie 105 der Fig. 6 - 7 ist neben der Potentialtrennung eine Abschirmung heißer Gase erzielbar.

Dabei wird im Vergleich zur weiteren Folie 105" der Fig. 8 und 9 weniger Material benötigt und eine Herstellung/Falzung ist einfacher.

## Patentansprüche

1. LED-Treiber (1), aufweisend
ein elektrisch leitfähiges Gehäuse (101);
eine Hauptplatine (102), aufweisend
Schaltungskomponenten zum Regeln einer zwischen einem Netzanschluss (103) und einem Gleichstrom-Anschluss des LED-Treibers (1) übertragenen elektrischen Leistung; und
eine Leiterbahn-Sicherung (104) zum Schutz des LED-Treibers (1) vor elektrischer Überlastung; und
zumindest eine Folie (105, 105', 105") zwischen dem Gehäuse (101) und der Hauptplatine (102);
wobei die zumindest eine Folie (105, 105', 105") derartig ausgebildet ist, dass sie einen Luftspalt zwischen sich und der Hauptplatine (102) im Wesentlichen ausfüllt,
**dadurch gekennzeichnet, dass**
die zumindest eine Folie (105, 105', 105") derartig ausgebildet ist, dass sie den Netzanschluss (103) von Emissionen infolge eines Auslösens der Sicherung (104) abschirmt.

2. LED-Treiber (1) nach Anspruch 1,
wobei die zumindest eine Folie (105, 105', 105") eine Folie (105) mit einem das Gehäuse (101) auskleidenden Hauptabschnitt (106), einem daran anschließenden Umschlagfalzabschnitt (107) und einem daran anschließenden Stehfalzabschnitt (108) umfasst.

3. LED-Treiber (1) nach Anspruch 2,
wobei der Umschlagfalzabschnitt (107) über eine Umschlagfalzlinie (109) in das Gehäuse (101) hinein falzbar ist.

4. LED-Treiber (1) nach Anspruch 2 oder Anspruch 3,
wobei der Stehfalzabschnitt (108) über eine Stehfalzlinie (110) von dem Umschlagfalzabschnitt (107) abstehend falzbar ist.

5. LED-Treiber (1) nach einem der Ansprüche 2 bis 4,
wobei der Umschlagfalzabschnitt (107), der Stehfalzabschnitt (108) und die Hauptplatine (102) in einer Richtung der Falzlinien (109, 110) im Wesentlichen identisch bemessen sind.

6. LED-Treiber (1) nach einem der Ansprüche 2 bis 4,
wobei der Umschlagfalzabschnitt (107) in einer zu der Umschlagfalzlinie (109) senkrechten Richtung derartig bemessen ist, dass der in das Gehäuse (101) hinein gefalzte Umschlagfalzabschnitt (107) zwischen dem Netzanschluss (103) und der Sicherung (104) abschließt.

7. LED-Treiber (1) nach einem der Ansprüche 2 bis 4,
wobei der Stehfalzabschnitt (108) in einer zu der Stehfalzlinie (110) senkrechten Richtung derartig bemessen ist, dass der von dem Umschlagfalzabschnitt (107) abstehend gefalzte Stehfalzabschnitt (108) den Luftspalt zwischen der einen Folie (105) und der Hauptplatine (102) im Wesentlichen ausfüllt.

8. LED-Treiber (1) nach Anspruch 1,
wobei die zumindest eine Folie (105, 105', 105") eine das Gehäuse (101) auskleidende Folie (105) und eine weitere Folie (105', 105") mit einem Hauptabschnitt (106') und einen Stehfalzabschnitt (108') umfasst.

9. LED-Treiber (1) nach Anspruch 8,
wobei der Stehfalzabschnitt (108') der weiteren Folie (105', 105") über eine Stehfalzlinie (110') von der weiteren Folie (105', 105") abstehend falzbar ist.

10. LED-Treiber (1) nach Anspruch 9,
wobei die weitere Folie (105', 105") derartig zwischen der einen Folie (105) und der Hauptplatine (102) angeordnet ist, dass die Stehfalzlinie (110') der weiteren Folie (105', 105") zwischen dem Netzanschluss (103) und der Sicherung (104) angeordnet und im Wesentlichen parallel zu der Stehfalzlinie (110) der einen Folie (105) ausgerichtet ist.

11. LED-Treiber (1) nach einem der Ansprüche 8 bis 10,
wobei der Hauptabschnitt (106') der weiteren Folie (105', 105"), der Stehfalzabschnitt (108') der weiteren Folie (105', 105") und die Hauptplatine (102) in einer Richtung der Stehfalzlinie (110') der weiteren Folie (105', 105") im Wesentlichen identisch bemessen sind.

12. LED-Treiber (1) nach einem der Ansprüche 8 bis 11,
wobei der Stehfalzabschnitt (108') der weiteren Folie (105', 105") in einer zu dessen Stehfalzlinie (108') senkrechten Richtung derartig bemessen ist, dass der von der weiteren Folie (105', 105") abstehend gefalzte Stehfalzabschnitt (108') den Luftspalt zwischen der einen Folie (105) und der Hauptplatine (102) im Wesentlichen ausfüllt.

## Claims

1. LED driver (1) comprising
an electrically conductive housing (101);
a main board (102) having
circuit components for controlling electrical power transmitted between a mains connection (103) and a DC connection of the LED driver (1); and
a conductor track fuse (104) for protecting the LED driver (1) from electrical overload; and
at least one film (105, 105', 105") between the housing (101) and the main board (102);
the at least one film (105, 105', 105") being designed such that it substantially fills an air gap between itself and the main board (102),
**characterized in that**
the at least one film (105, 105', 105") is designed such that it shields the mains connection (103) from emissions resulting from triggering of the fuse (104).

2. LED driver (1) according to claim 1,
wherein the at least one film (105, 105', 105") comprises a film (105) having a main portion (106) lining the housing (101), an adjoining folded-over portion (107) and an adjoining standing folded portion (108).

3. LED driver (1) according to claim 2,
wherein the folded-over portion (107) can be folded into the housing (101) via a fold-over line (109).

4. LED driver (1) according to either claim 2 or claim 3,
wherein the standing folded portion (108) can be folded via a standing fold line (110) so as to protrude from the folded-over portion (107).

5. LED driver (1) according to any of claims 2 to 4,
wherein the folded-over portion (107), the standing folded portion (108) and the main board (102) have substantially identical dimensions in a direction of the fold lines (109, 110).

6. LED driver (1) according to any of claims 2 to 4,
wherein the folded-over portion (107) is dimensioned in a direction perpendicular to the fold-over line (109) such that the folded-over portion (107) folded into the housing (101) terminates between the mains connection (103) and the fuse (104).

7. LED driver (1) according to any of claims 2 to 4,
wherein the standing folded portion (108) is dimensioned in a direction perpendicular to the standing fold line (110) such that the standing folded portion (108) folded so as to protrude from the folded-over portion (107) substantially fills the air gap between the one film (105) and the main board (102).

8. LED driver (1) according to claim 1,
wherein the at least one film (105, 105', 105") comprises a film (105) lining the housing (101) and a further film (105', 105") having a main portion (106') and a standing folded portion (108').

9. LED driver (1) according to claim 8,
wherein the standing folded portion (108') of the further film (105', 105") can be folded via a standing fold line (110') so as to protrude from the further film (105', 105").

10. LED driver (1) according to claim 9,
wherein the further film (105', 105") is arranged between the one film (105) and the main board (102) such that the standing fold line (110') of the further film (105', 105") is arranged between the mains connection (103) and the fuse (104) and is aligned substantially parallel to the standing fold line (110) of the one film (105).

11. LED driver (1) according to any of claims 8 to 10,
wherein the main portion (106') of the further film (105', 105"), the standing folded portion (108') of the further film (105', 105") and the main board (102) have substantially identical dimensions in a direction of the standing fold line (110') of the further film (105', 105").

12. LED driver (1) according to any of claims 8 to 11,
wherein the standing folded portion (108') of the further film (105', 105") is dimensioned in a direction perpendicular to the standing fold line (108') thereof such that the standing folded portion (108') folded so as to protrude from the further film (105', 105") substantially fills the air gap between the one film (105) and the main board (102).

## Revendications

1. Pilote pour DEL (1), présentant
un boîtier électroconducteur (101) ;
une carte principale (102), présentant
des composants de circuit destinés à réguler une puissance électrique transmise entre un raccord au réseau (103) et un raccord de courant continu du pilote pour DEL (1) ; et
un fusible de piste conductrice (104) destiné à protéger le pilote pour DEL (1) contre les surcharges électriques ; et
au moins un film (105, 105', 105") entre le boîtier (101) et la carte principale (102) ;
dans lequel l'au moins un film (105, 105', 105") est conçu de manière à remplir sensiblement un entrefer entre lui-même et la carte principale (102),
**caractérisé en ce que**
l'au moins un film (105, 105', 105") est conçu de manière à protéger le raccord au réseau (103) des émissions résultant d'un déclenchement du fusible (104).

2. Pilote pour DEL (1) selon la revendication 1,
dans lequel l'au moins un film (105, 105', 105") comprend un film (105) comportant une section principale (106) revêtant le boîtier (101), une section de pliage de rabattement (107) s'y raccordant et une section de pliage vertical (108) s'y raccordant.

3. Pilote pour DEL (1) selon la revendication 2,
dans lequel la section de pliage de rabattement (107) peut être pliée dans le boîtier (101) par l'intermédiaire d'une ligne de pliage de rabattement (109).

4. Pilote pour DEL (1) selon la revendication 2 ou la revendication 3,
dans lequel la section de pliage vertical (108) peut être pliée de manière à dépasser de la section de pliage de rabattement (107) par l'intermédiaire d'une ligne de pliage vertical (110).

5. Pilote pour DEL (1) selon l'une des revendications 2 à 4,
dans lequel la section de pliage de rabattement (107), la section de pliage vertical (108) et la carte principale (102) sont dimensionnées de manière sensiblement identique dans une direction des lignes de pliage (109, 110).

6. Pilote pour DEL (1) selon l'une des revendications 2 à 4,
dans lequel la section de pliage de rabattement (107) est dimensionnée dans une direction perpendiculaire à la ligne de pliage de rabattement (109) de telle sorte que la section de pliage de rabattement (107) pliée dans le boîtier (101) se termine entre le raccord au réseau (103) et le fusible (104).

7. Pilote pour DEL (1) selon l'une des revendications 2 à 4,
dans lequel la section de pliage vertical (108) est dimensionnée dans une direction perpendiculaire à la ligne de pliage vertical (110) de telle sorte que la section de pliage vertical (108) pliée de manière à dépasser de la section de pliage de rabattement (107) remplit sensiblement l'entrefer entre l'au moins un film (105) et la carte principale (102).

8. Pilote pour DEL (1) selon la revendication 1,
dans lequel l'au moins un film (105, 105', 105") comprend un film (105) revêtant le boîtier (101) et un autre film (105', 105") comportant une section principale (106') et une section de pliage vertical (108').

9. Pilote pour DEL (1) selon la revendication 8,
dans lequel la section de pliage vertical (108') de l'autre film (105', 105") peut être pliée de manière à dépasser de l'autre film (105', 105") par l'intermédiaire d'une ligne de pliage vertical (110').

10. Pilote pour DEL (1) selon la revendication 9,
dans lequel l'autre film (105', 105") est disposé entre le premier film (105) et la carte principale (102) de telle sorte que la ligne de pliage vertical (110') de l'autre film (105', 105") est disposée entre le raccord au réseau (103) et le fusible (104) et est orientée sensiblement parallèlement à la ligne de pliage vertical (110) du premier film (105).

11. Pilote pour DEL (1) selon l'une des revendications 8 à 10,
dans lequel la section principale (106') de l'autre film (105', 105"), la section de pliage vertical (108') de l'autre film (105', 105") et la carte principale (102) sont dimensionnées de manière sensiblement identique dans une direction de la ligne de pliage vertical (110') de l'autre film (105', 105").

12. Pilote pour DEL (1) selon l'une des revendications 8 à 11,
dans lequel la section de pliage vertical (108') de l'autre film (105', 105") est dimensionnée dans une direction perpendiculaire à sa ligne de pliage vertical (108') de telle sorte que la section de pliage vertical (108') pliée de manière à dépasser de l'autre film (105', 105") remplit sensiblement l'entrefer entre le premier film (105) et la carte principale (102).
